# EUROPÄISCHE PATENTSCHRIFT

(11) **EP 1 644 954 B1**
(45) Veröffentlichungstag und Bekanntmachung des Hinweises auf die Patenterteilung: **08.05.2013**
(21) Anmeldenummer: 04766096.4
(22) Anmeldetag: 29.06.2004
(51) Int. Cl.: H01L 21/3065, H01J 37/32

(54) **VERFAHREN ZUM ANISOTROPEN ÄTZEN EINER AUSNEHMUNG IN EIN SILIZIUMSUBSTRAT UND VERWENDUNG EINER PLASMAÄTZANLAGE**
METHOD FOR ANISOTROPICALLY ETCHING A RECESS IN A SILICON SUBSTRATE AND USE OF A PLASMA ETCHING SYSTEM
PROCEDE POUR FORMER PAR GRAVURE ANISOTROPE, UNE CAVITE DANS UN SUBSTRAT DE SILICIUM, ET UTILISATION D'UN DISPOSITIF DE GRAVURE AU PLASMA

(30) Priorität: 11.07.2003 DE 10331526
(43) Veröffentlichungstag der Anmeldung: 12.04.2006
(73) Patentinhaber: Infineon Technologies AG, 85579 Neubiberg (DE)
(72) Erfinder: HANEWALD, Thorsten, 67098 Bad Dürkheim (DE); HAUSER, Andreas, 86529 Schrobenhausen (DE); JANSSEN, Ingold, 81737 München (DE); SUBKE, Kai-Olaf, 85567 Grafing (DE)
(74) Vertreter: Kindermann, Peter
(86) Internationale Anmeldenummer: PCT/EP2004/051285
(87) Internationale Veröffentlichungsnummer: WO 2005/008760

(56) Entgegenhaltungen:
- WO-A-02/23609
- WO-A1-01/47005
- US-A- 5 935 874
- US-A1- 2001 001 743
- US-A1- 2003 022 512
- US-B1- 6 491 835

## Beschreibung

Die Erfindung betrifft ein Verfahren, bei dem ein Plasma zur energetischen Anregung eines reaktiven Ätzgases eingesetzt wird. Das Ätzgas dient zum anisotropen Ätzen einer Ausnehmung.

Die Ausnehmung ist beispielsweise ein Graben, bei dem am Öffnungsrand eine laterale Abmessung mindestens doppelt so groß ist wie eine im Winkel von 90° dazu quer liegende laterale Abmessung, oder ein Loch, bei dem am Öffnungsrand eine laterale Abmessung höchstens doppelt so groß ist wie eine im Winkel von 90 ° dazu quer liegende laterale Abmessung. Bei einem Loch sind die beiden lateralen Abmessungen vorzugsweise gleich groß. Die Öffnung ist im Fall eines Grabens oval oder rechteckig. Im Fall eines Loches ist die Öffnung oval, kreisrund, rechteckig oder quadratisch. Oft werden sowohl Löcher als auch Gräben als Trenches bezeichnet.. Bei Löchern ist das Ätzen schwieriger als bei Gräben, da die Ätzgase im Vergleich zu einem Graben mit gleicher Tiefe und gleicher Breite den Lochboden schwerer erreichen können. Beispiele für Ausnehmungen in der Mikromechanik sind weiterhin Ausnehmungen um Balken, Kämme oder Zungen herum.

Aus der WO 00/63960 ist ein Prozess zum Ätzen einer Siliziumschicht bis in eine Tiefe von 60 Mikrometern bekannt. Gemäß Tabelle 2 liegt ein Verhältnis von O₂-Gasfluss zum gesamten reaktiven Gasfluss bei 0,44; 0,2, 0,2 bzw. bzw. Das Verhältnis von inertem Gasfluss zum gesamten Gasfluss liegt bei 0,4; 0,21;
0,21 bzw. 0,137. Aus dem Dokument WO 01/47005 A1 ist ein Metallmaskenätzen von Silizium bekannt.

Es ist Aufgabe der Erfindung ein einfaches Verfahren zum Ätzen einer Ausnehmung mit einer Tiefe von mindestens 75 Mikrometern anzugeben. Außerdem soll eine Verwendung einer Plasmaätzanlage angegeben werden.

Die auf das Verfahren bezogen Aufgabe wird durch eine Verfahren mit den im Patentanspruch 1 angegebenen Verfahrensschritten gelöst. Weiterbildungen sind in den Unteransprüche angegeben.

Die Erfindung geht von der Überlegung aus, dass in der Halbleitertechnik u.a. Gräben bzw. Löcher mit einer lateralen Abmessung kleiner als 190 nm (Nanometer) oder sogar kleiner als 90 nm benötigt werden. Die Tiefe der Gräben ist kleiner als 10 Mikrometer, typischerweise 7 Mikrometer oder 3 Mikrometer. Diese Trenches dienen zur Aufnahme von Kondensatoren flüchtig Ladungen speichernder Speicherzellen. Außerdem lassen sich solche Gräben bspw. zur Isolierung von Transistoren nutzen. Das Aspektverhältnis von Tiefe zu kleinster lateraler Abmessung am Öffnungsrand ist größer als 50:1 insbesondere größer als 70:1. Zum Ätzen wird bspw. Schwefeltrifluorid NF₃ und HBr₂ eingesetzt. Eine Schwierigkeit bei diesen Trenches liegt bspw. darin eine Ätzmaske zu schaffen, die auch noch nach mehreren Mikrometern Ätzen des Siliziumsubstrates vorhanden ist und ihre Maskenfunktion beibehält. Damit lässt sich die Tiefe der Trenches nicht beliebig erhöhen.

Weiterhin geht die Erfindung von der Überlegung aus, dass in der Mikromechanik Gräben mit Tiefen von mehreren 100 Mikrometern geätzt werden. Die Aspektverhältnisse sind moderater und sind beispielsweise kleiner als 20:1 oder sogar kleiner als 10:1. Hier werden als Ätzgase Schwefelhexafluorid SF₆ und/oder Stickstofftrifluorid NF₃ eingesetzt. Um Gräben mit Tiefen von mehr als 50 Mikrometer zu ätzen werden zyklische Verfahren eingesetzt, bei denen wiederholt nach einem Ätzschritt in einem Abscheideschritt eine Schutzschicht an den Wänden der Gräben erzeugt wird. Die zyklische Prozessführung mit bspw. mehreren hundert Zyklen erfordert jedoch teure Spezialanlagen und führt zu ungleichmäßigen Trenchwänden, d.h. zum sogenannten "scallopping".

Es wurde überraschenderweise festgestellt, dass eine zyklische Prozessführung nicht zwingend ist. Deshalb ist bei dem erfindungsgemäßen Verfahren das reaktive Ätzgas Bestandteil eines kontinuierlichen Gasflusses. Ohne zwischenzeitliche Unterbrechung des Gasflusses wird mindestens eine Ausnehmung um mindestens fünfzig Mikrometer oder um mindestens einhundert Mikrometer vertieft. Dadurch lassen sich zum Ätzen tiefer Gräben einfache Ätzanlagen einsetzen, z.B. Ätzanlagen wie sie für eine Ätzung von polykristallinem Silizium benötigt werden. Außerdem sind keine hohen Pumpleistungen und hochwertige Gasflusssteuereinheiten erforderlich, wie bei einem bei niedrigen Drücken ausgeführten Verfahren mit zyklischen Gasflüssen.

Bei einer Weiterbildung enthält das reaktive Ätzgas Fluor oder Fluorverbindungen, vorzugsweise Schwefelhexafluorid SF₆ und/oder Stickstofftrifluorid NF₃, insbesondere nur eine Art von Fluorverbindungen. Durch die Verwendung von Schwefelhexafluorid SF₆ in einem hochdichten Plasma lassen sich ausreichend viele Fluorradikale pro Ätzfläche erzeugen, so dass Ätzraten bis zu 6 Mikrometer pro Minute erreicht werden. Die genannten Fluorverbindungen sind ungefährlicher als molekulares Fluor. Im Vergleich zu anderen Halogenen bzw. Halogenverbindungen ist Fluor bzw. eine Fluorverbindung reaktiver.

Bei einer anderen Weiterbildung enthält das Ätzgas nur ein Edelgas, nämlich Helium oder Argon. Alternativ enthält das Ätzgas mehrere Edelgase, nämlich Helium und Argon.

Der Anteil des Argongasflusses am gesamten inerten Gasfluss liegt zwischen 25 % und 65 % oder zwischen 35 % und 55 %. Die Verdünnung des aktiven Gases mit einem Inertgas führt zu einer verbesserten Ätzgleichmäßigkeit über einen Wafer mit einem Durchmesser größer 150 mm (Millimeter), größer 200 mm oder sogar größer als 300 mm. Außerdem wird die Selektivität der Hartmaske erhöht. Weiterhin stabilisiert sich durch die Verdünnung mit dem Edelgas der Gesamtprozess in Hinblick auf unvermeidliche Schwankungen des Gasflusses.

Bei einer nächsten Weiterbildung liegt der Anteil des Gasflusses aus reaktiven Ätzgas am Gesamtgasfluss im Bereich zwischen 28 % und 32 liegt %. Durch den Anteil des reaktiven Ätzgases am Gesamtgasfluss lässt sich die Ätzrate und die Unterätzung steuern.

Bei einer Weiterbildung ist der Druck beim Ätzen größer als 0,05 mbar oder größer als 0,1 mbar ist. Der Druck beim Ätzen ist vorzugsweise kleiner als 0,5 mbar oder kleiner als 0,25 mbar. Über den Druck lässt sich die Ätzrate, die Neigung oder Seitenwände des Trenches und die Unterätzung steuern.

Das Plasma wird bei einer Weiterbildung mit Leistungen zwischen 300 Watt und 1200 Watt oder zwischen 500 Watt und 1000 Watt erzeugt, insbesondere mit 600 Watt. Zu große Leistung führen zu einer zu starken Überhitzung. Zu kleine Leistungen führen zu geringen Ätzraten. Die Frequenz zur Erzeugung des Plasmas ist bei einer Ausgestaltung kleiner als 100 MHz, bspw. bei einer induktiven Einkopplung mit 13,56 MHz. Alternativ wird jedoch auch mit einer elektromagnetischen Strahlung im Mikrowellenbereich Leistung in das Plasma eingekoppelt, d.h. mit einer Frequenz größer 1 Gigahertz, insbesondere 2,45 GHz.

Bei einer nächsten Weiterbildung wird eine Substratvorspannung mit Leistungen größer 50 Watt oder größer 60 Watt erzeugt, vorzugsweise mit Leistungen größer 70 Watt. Die Leistung zur Erzeugung der Substratvorspannung ist vorzugsweise kleiner als 700 Watt. Äquivalent beträgt die Substratvorspannung betragsmäßig mehr als 150 Volt oder mehr als 210 Volt. Vorzugsweise ist die Substratvorspannung kleiner als 600 Volt. Die betragsmäßig vergleichsweise hohe Substratvorspannung führt zu einer erhöhten Ioneneinwirkung auf den Trenchboden und damit zu einem schnellen Abtrag. Die Frequenz zum Erzeugen der Substratvorspannung ist vorzugsweise kleiner als 100 MHz.

Folgende optimierte Werte gelten für eine nächste Weiterbildung:
- Gasdruck 120 µbar,
- Plasmaleistung 600 Watt,
- Substratvorspannung -220 Volt,
- Heliumgasfluss 126 sccm,
- Sauerstoffgasfluss 32 sccm,
- Schwefelhexafluoridgasfluss 59 sccm,
- Argongasfluss 84 sccm,
wobei vorzugsweise keine weiteren Gase verwendet werden. Auch Abweichungen dieser Werte um plus oder minus fünf bzw. zehn Prozent liegen noch im Rahmen der Optimierung.

Bei dem erfindungsgemäßen Verfahren, insbesondere bei dem optimierten Verfahren, ist kein Temperaturzyklus erforderlich, da die Temperatur unverändert bleibt, z.B. bei 45 °C (Grad Celsius). Eine höhere Temperatur führt zu einer steigenden Ätzrate. Eine kleinere Temperatur führt zu einem stärkeren Seitenwandschutz. Abgesehen von dem standardgemäßen waferlosen Vorkonditionieren und den Selbstreinigungsverfahren ist keine zusätzliche Konditionierung erforderlich. Damit lässt sich die Ätzung von Trenches mit mehr als 50 Mikrometern in die Standard Halbleiterproduktion einführen.

Bei einer weiterbildung ist die Ausnehmung ein Graben oder ein Loch. Die Anwendbarkeit des Verfahrens auf die Ätzung von tiefen Löchern ist besonders überraschend und war nicht vorherzusehen. Trotz der engen Ausnehmung kann um mehr als 50 Mikrometer mit einem kontinuierlichen Verfahren geätzt werden, ohne dass die Ätzung zum Erliegen kommt, bspw. wenn Ätzgase den Lochboden nicht erreichen. Das Aspektverhältnis zwischen kleinster lateraler Abmessung am Rand der Ausnehmung und der kontinuierlich geätzten Tiefe der Aussparung ist bei einer Ausgestaltung größer als 8:1 oder größer als 10:1.

Die kleinste laterale Abmessung am Rand der Aussparung ist bei einer alternativen oder zusätzlichen Ausgestaltung kleiner als zwanzig Mikrometer oder kleiner als zehn Mikrometer.

Bei einer anderen Ausgestaltung ist der Anteil der Öffnung der Aussparung oder der Öffnungen der Aussparungen bezogen auf die Größe der ursprünglichen Substratoberfläche, in die die Ausnehmung eingebracht wird, kleiner als 20 % oder kleiner als 10 % oder kleiner als 5 %. Je kleiner der Anteil, um so größer sind die erreichbaren Ätzraten.

Bei einer Weiterbildung ist der Neigungswinkel einer Wand einer sich mit zunehmenden Abstand zur Substratoberfläche verjüngenden Ausnehmung zu der den Rand der Aussparung enthaltenden Substratoberfläche größer als 91 Grad größer als 92 Grad oder größer als 93 Grad ist, wobei der Neigungswinkel vorzugsweise kleiner als 110 Grad ist. Zwischen den Schenkeln des Winkels liegt Siliziumsubstrat. Wird ein Winkel zwischen der Seitenwand und der Substratoberfläche betrachtet, zwischen dessen Schenkeln ein substratfreier Raum liegt, so sind die Winkel kleiner als 89°, kleiner als 88° oder kleiner als 87°. Eine sich stärker verjüngende Aussparung ist leichter zu füllen als eine Aussparung mit parallelen Seitenwänden. Ein zu starkes verjüngen begrenzt die Tiefe der Ausnehmung. Der Neigungswinkel wird vorzugsweise über einen Sauerstoffanteil im Prozessgas eingestellt.

Bei einer nächsten Weiterbildung wird eine Ätzmaske zum Festlegen der Lage der Ausnehmung verwendet, insbesondere eine Ätzmaske aus Siliziumdioxid. Das Siliziumdioxid wurde bspw. mit einem TEOS-Verfahren (Tetra Ethyl Ortho Silicate) erzeugt. Auch thermisches Siliziumdioxid ist als Material der Ätzmaske geeignet.

Bei einer nächsten Weiterbildung wird in eine zum Ätzen genutzte Prozess- bzw. Ätzkammer von außen kein siliziumhaltiges Gas eingeleitet, insbesondere kein Gas mit Verbindungen, die Silizium und Fluor enthalten, wie z.B. SiF₄. Dadurch vereinfacht sich die Verfahrensführung.

Bei einer nächsten Weiterbildung liegt der Gesamtgasfluss zwischen 200 sccm (Standard Kubikzentimeter) und 500 sccm oder zwischen 250 sccm und 350 sccm liegt, vorzugsweise zwischen 295 sccm und 305 sccm. Diese Gasflüsse wurden für ein Ätzkammervolumen wie in einer Anlage vom Typ Lam TCP 9400 PTX ermittelt, d.h. für ein Volumen von etwa 30 Litern. Wichtig für den Prozess sind die mittleren Verweilzeiten der Spezies. Die mittlere Verweilzeit ergibt sich aus dem Verhältnis von Gasfluss und Gasdruck, so dass mit den oben stehenden Angaben eine Umrechnung auf größere oder kleinere Kammervolumen möglich ist.

Gemäß einem weiteren Aspekt der Erfindung wird die auf die Verwendung bezogene Aufgabe durch die Verwendung einer Plasmaätzanlage für das Ätzen mindestens einer Ausnehmung mit einer Tiefe größer als fünfzig Mikrometer oder größer als einhundert Mikrometer bei kontinuierlichem Gasfluss, d.h. ohne zwischenzeitliche Unterbrechung, von in eine Ätzkammer der Plasmaätzanlage einströmenden Gasen gelöst.

Bei einer Weiterbildung der Verwendung enthält die Plasmaätzanlage keine Steuereinheit für ein zyklisches Ätzen. Dennoch wird die Anlage zum Ätzen von Gräben bzw. Löchern tiefer als 50 Mikrometer verwendet. Bei einer Ausgestaltung wird die Plasmaätzanlage außerdem zur Ätzung von polykristallinen Siliziumschichten eingesetzt, insbesondere bei der Prozessierung von Wafern, die eine Vielzahl von integrierten Schaltungen enthalten, bspw. von MOS-Schaltungen (Metal Oxide Semiconductor), CMOS-Schaltungen (Complementary MOS), BiCMOS (Bipolar CMOS) oder von reinen Bipolarschaltungen. Damit ist für die Trenchätzung in Tiefen größer 50 Mikrometer keine teure Spezialanlage mehr erforderlich.

Bei einer Weiterbildung bleibt die Zusammensetzung des Gasflusses während des Ätzens der Ausnehmung gleich. Alternativ oder zusätzlich bleibt auch die Größe des Gasflusses während des Ätzens der Ausnehmung gleich. Damit ist eine einfache Verfahrensführung möglich. Jedoch sind auch Verfahren möglich, bei denen trotz kontinuierlichem Gasfluss die Gasflussmenge beim Ätzen verändert wird, bspw. um das Profil des Trenches zu beeinflussen oder um gleichmäßiger Verhältnisse am Trenchboden während der gesamten Ätzung zu schaffen.

Im Folgenden werden Ausführungsbeispiele der Erfindung an Hand der beiliegenden Zeichnungen erläutert. Darin zeigen:
- Figur 1: den Aufbau einer Plasmaätzanlage,
- Figur 2: eine Prinzipdarstellung der Vorgänge beim Ätzen, und
- Figuren 3A bis 3C: Querschnitte durch Gräben mit unterschiedlichen Seitenwandneigungen auf Grund dreier verschiedener Verfahrensführungen.

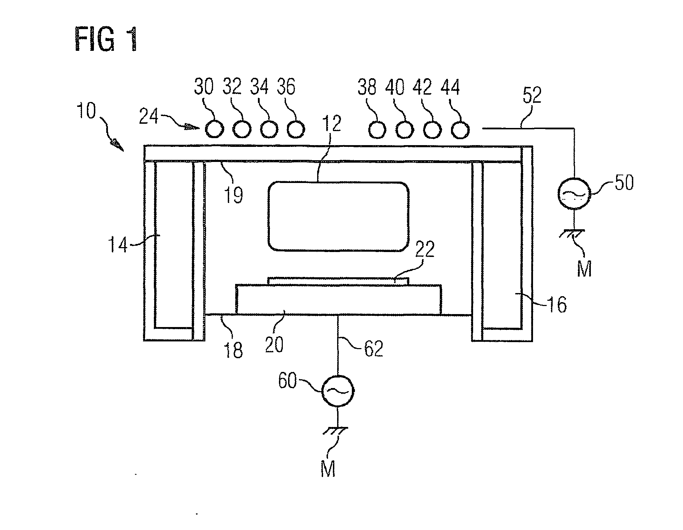

Figur 1 zeigt eine Plasmaätzanlage 10, bspw. eine Plasmaätzanlage vom Typ Lam TCP 9400 PTX. Eine Ätzkammer mit einem Plasma 12 wird von Seitenwänden, von einem Kammerboden 18 und von einer Kammerdecke 19 begrenzt. In der Ätzkammer befindet sich am Kammerboden 18 ein Substratträger 20, der einen Siliziumwafer 22 trägt.

Außerdem enthält die Ätzkammer einen oder mehrere nicht dargestellte Gaseinlassöffnungen, in die ein Gasgemisch aus Argon, Helium, Schwefelhexafluorid SF₆ und Sauerstoff einströmt. Durch eine oder mehrere nicht dargestellte Gasauslassöffnungen strömen ein Teil des eingelassenen Gasgemisches sowie Reaktionsprodukte wieder aus.

Die Plasmaätzanlage enthält außerdem eine oberhalb der Ätzkammer oder im oberen Bereich der Ätzkammer angeordnete Spule 24 mit Windungen 30 bis 44. Ein Anschluss der Spule ist mit einer Wechselspannungsquelle 50 über eine Leitung 52 leitfähig verbunden. Der andere Anschluss der Wechselspannungsquelle 50 liegt auf einem Massepotential M. Die Frequenz der Wechselspannungsquelle 50 beträgt 13,56 MHz. Die Wechselspannungsquelle 50 verbraucht eine Leistung von 600 Watt, um das Plasma 12 zu erzeugen.

Weiterhin enthält die Plasmaätzanlage 10 eine Wechselspannungsquelle 60, die mit einer Frequenz von 13,56 MHz betrieben wird. Der eine Anschluss der Wechselspannungsquelle 60 ist über eine elektrisch leitfähige Leitung 62 mit dem elektrisch leitfähigen Substratträger 20 verbunden. Der andere Anschluss der Wechselspannungsquelle 60 ist mit dem Massepotential M verbunden. Die Wechselspannungsquelle 60 erzeugt eine Substratvorspannung von -220 Volt unter einem Leistungsverbrauch von bspw. 70 Watt.

Die Wechselspannungsquellen 50 und 60 sind unabhängig voneinander steuerbar, so dass sich die Ionendichte und die Ionenenergie unabhängig voneinander regeln lassen. Weiterhin lässt sich die Relation geladener Teilchen zu ungeladenen Teilchen vorgeben.

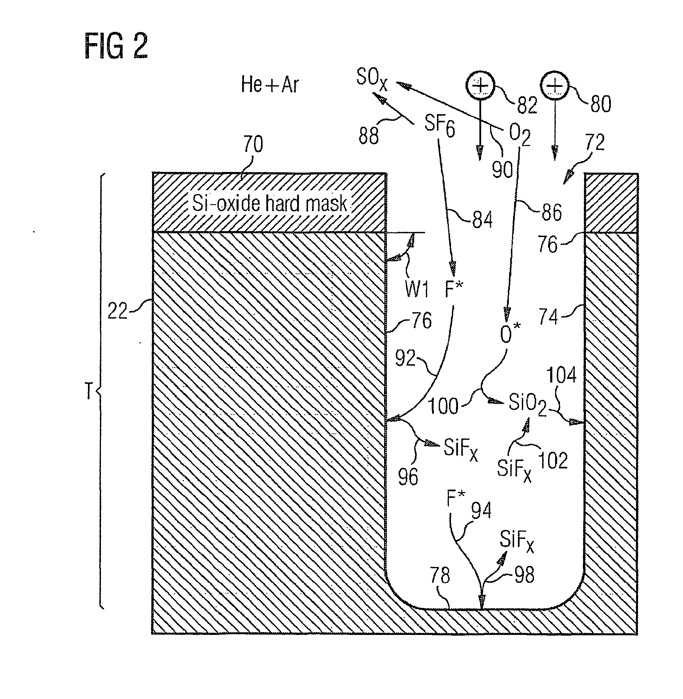

Figur 2 zeigt eine Prinzipdarstellung der Vorgänge beim Ätzen in der Ätzkammer der Plasmaätzanlage 10. Auf dem Siliziumsubstrat 22 wurde vor dem Einbringen in die Ätzkammer eine Hartmaske 70 aus Siliziumdioxid mit Hilfe eines fotolithografischen Prozesses erzeugt, um die Lage von Löchern vorzugeben, insbesondere die Lage eines Loches 72. Die Hartmaske 70 hat beispielsweise für Ausnehmungen mit einer Tiefe von 100 Mikrometern bzw. einer Ätzzeit von 1000 Sekunden eine Dicke von 2,5 Mikrometern, wobei eine Ätzreserve von etwa 300 Nanometern enthalten ist. Die Löcher haben runde Öffnungen 74, umlaufende Seitenwände 76 sowie abgerundete Lochböden 78. Die Löcher werden gleichzeitig mit gleichen Tiefen geätzt. Das Loch 72 hat im Ausführungsbeispiel eine Tiefe T von 75 Mikrometern.

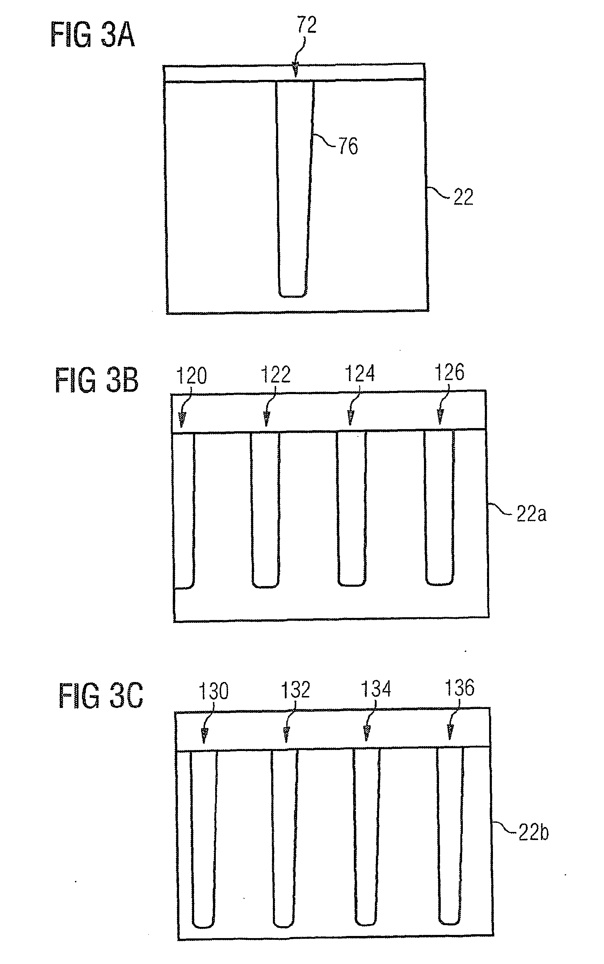

Zum Ätzen des Loches 72, das auch in Figur 3 A dargestellt ist, wurden folgende konstante Parameter eingehalten:
- Gasdruck 120 µbar,
- Plasmaleistung 600 Watt,
- Substratvorspannung -220 Volt
- Heliumgasfluss 126 sccm,
- Sauerstoffgasfluss 32 sccm,
- Schwefelhexafluoridgasfluss 59 sccm, und
- Argongasfluss 84 sccm.

Damit wurden folgende Ätzergebnisse erreicht:
- Lochtiefe T: 75 Mikrometer,
- Lochdurchmesser an der Öffnung 76: 10 Mikrometer,
- geöffnete Fläche: 4 % (3 % bis 5 %),
- Neigungswinkel W1 der Seitenwand 76: 87 °,
- bzw. Neigungswinkel W2 der Seitenwand 76: 93°, und
- Ätzrate: 6 Mikrometer/Minute.

In der Ätzkammer laufen unter anderem die folgenden Reaktionen bzw. Vorgänge ab:
- Ionen, insbesondere Kationen 80, 82 werden aus dem Plasma auf Grund der Substratvorspannung bis zum Lochboden 78 beschleunigt und verhindern dort die Bildung eines Siliziumdioxidfilms.
- unter der Einwirkung des Plasmas 12 bilden sich aus dem Schwefelhexafluorid SF₆ Fluorradikale F*, siehe Pfeil 84, und Schwefelradikale,
- unter der Einwirkung des Plasmas 12 bilden sich aus dem molekularen Sauerstoff Sauerstoffradikale O*, siehe Pfeil 86,
- Die Schwefelradikale und eine Teil der Sauerstoffradikale O* reagieren zu Schwefeloxidverbindungen SO_{×}, z.B. zu Schwefelmonoxid SO oder zu Schwefeldioxid SO₂, siehe Pfeile 88 und 90,
- Fluorradikale F* reagieren mit dem Silizium des Siliziumsubstrates 22 an noch nicht oder noch nicht ausreichend mit Siliziumdioxid bedeckten Stellen der Seitenwand 76, insbesondere in der Nähe des Grabenbodens 78, siehe Pfeil 92, mit dem Silizium am Grabenboden 78, siehe Pfeil 94. Dabei entstehen Siliziumfluorverbindungen SiF_{×}, z.B. Siliziumtetrafluorid SiF4, siehe Pfeile 96 und 98,
- Ein anderer Teil der Sauerstoffradikale O* reagiert mit den Siliziumfluorverbindungen SiF_{×} zu Siliziumdioxid SiO₂, das sich an der Seitenwand 76 ablagert, siehe Pfeile 100, 102 und 104. Andere Sauerstoffradikale O* reagieren auch direkt mit dem Silizium des Siliziumsubstrates 22 zu Siliziumdioxid SiO₂.

Eine Nachzeichnung eines SEM-Bildes (Secundary Electron Microscopy) entlang eines Querschnitts durch das Loch 72 ist in Figur 3A dargestellt.

Figur 3B zeigt eine Nachzeichnung eines SEM-Bildes entlang eines Querschnitts durch Löcher 120 bis 126, die mit den folgenden Prozessparametern geätzt worden sind:
- Gasdruck 93 µbar,
- Plasmaleistung 700 Watt,
- Substratvorspannung -200 Volt,
- Heliumgasfluss 131 sccm,
- Sauerstoffgasfluss 35 sccm,
- Schwefelhexafluoridgasfluss 53 sccm, und
- Argongasfluss 131 sccm.

Damit wurden folgende Ätzergebnisse erreicht:
- Lochtiefe T: 56 Mikrometer,
- Lochdurchmesser an der Öffnung: 10 Mikrometer,
- geöffnete Fläche: 4 % (3 % bis 5 %),
- Neigungswinkel W1 der Seitenwand 76: 89 °,
- bzw. Neigungswinkel W2 der Seitenwand 76: 91°, und
- Ätzrate: 4,5 Mikrometer/Minute.

Figur 3C zeigt eine Nachzeichnung eines SEM-Bildes entlang eines Querschnitts durch Löcher 130 bis 136, die mit den folgenden Prozessparametern geätzt worden sind:
- Gasdruck 120 µbar,
- Plasmaleistung 800 Watt,
- Substratvorspannung -220 Volt,
- Heliumgasfluss 112 sccm,
- Sauerstoffgasfluss 50 sccm,
- Schwefelhexafluoridgasfluss 66 sccm, und
- Argongasfluss 168 sccm.

Damit wurden folgende Ätzergebnisse erreicht:
- Lochtiefe T: 68 Mikrometer,
- Lochdurchmesser an der Öffnung: 10 Mikrometer,
- geöffnete Fläche: 4 % (3 % bis 5 %),
- Neigungswinkel W1 der Seitenwand 76: 88 °,
- bzw. Neigungswinkel W2 der Seitenwand 76: 92°, und
- Ätzrate: 5 Mikrometer/Minute.

Die Ausführungsbeispiele wurden für eine TCP-Prozesskammer (Transformer Coupled Plasma) erläutert. Solche Kammern werden u.a. auch als ICP- (Inductive Coupled Plasma source), IPS-(Inductive Coupled plasma Source) oder als DPS-Kammer (Decoupled Plasma Source) bezeichnet. Die Anlagen erzeugen ein HDP (High Density Plasma) mit mindestens 10¹⁰ Ionen pro Kubikzentimeter, vorzugsweise im Bereich zwischen 10¹¹ Ionen/cm³ und 10¹² Ionen/cm³.

## Patentansprüche

1. Verfahren zum anisotropen Ätzen einer Ausnehmung (72) in ein Siliziumsubstrat (22),
bei dem ein Plasma zur energetischen Anregung eines reaktiven Ätzgases eingesetzt wird,
bei dem das reaktive Ätzgas Bestandteil eines kontinuierlichen Gasflusses ist,
und bei dem ohne zwischenzeitliche Unterbrechung des Gasflusses mindestens eine Ausnehmung (72) um mindestens fünfundsiebzig Mikrometer oder um mindestens einhundert Mikrometer vertieft wird,
wobei das reaktive Ätzgas ein fluorfreies Zusatzgas enthält, nämlich einen Oxidbildner, und wobei das Ätzgas mit nur einem Inertgas oder Edelgas oder mit mehreren Inertgasen oder Edelgasen verdünnt ist,
und wobei der Anteil des fluorfreien Zusatzgases am gesamten aktiven Gasfluss zwischen 30 % und 40 % liegt,
und wobei der Anteil des Gasflusses aus reaktivem Ätzgas am Gesamtgasfluss im Bereich zwischen 25 % und 35 % liegt,
und wobei eine Ätzmaske (70) aus Siliziumdioxid zum Festlegen der Lage der Ausnehmung (72) verwendet wird,
und wobei die Zusammensetzung des Gasflusses während des Ätzens der Ausnehmung (72) gleich bleibt.

2. Verfahren nach Anspruch 1, **dadurch gekennzeichnet, dass** das reaktive Ätzgas Fluor oder Fluorverbindungen enthält, vorzugsweise Schwefelhexafluorid SF₆ und/oder Stickstofftrifluorid NF₃, insbesondere nur eine Art von Fluorverbindungen.

3. Verfahren nach Anspruch 1 oder 2, **dadurch gekennzeichnet , dass** das reaktive Ätzgas molekularen Sauerstoff enthält,
und/oder dass der Anteil des fluorfreien Zusatzgases, insbesondere der Anteil des Sauerstoffgasflusses, am gesamten aktiven Gasfluss bei 35 % liegt.

4. Verfahren nach einem der vorhergehenden Ansprüche, **dadurch gekennzeichnet, dass** das Ätzgas Helium oder Argon enthält oder dass das Ätzgas Helium und Argon enthält,
und/oder dass der Anteil des Argongasflusses am gesamten inerten Gasfluss zwischen 25 % und 65 % oder zwischen 35 % und 55 % liegt.

5. Verfahren nach einem der vorhergehenden Ansprüche, **dadurch gekennzeichnet, dass** der Anteil des Gasflusses aus reaktiven Ätzgas am Gesamtgasfluss im Bereich zwischen 28 % und 32 % liegt.

6. Verfahren nach einem der vorhergehenden Ansprüche, **dadurch gekennzeichnet, dass** der Druck beim Ätzen größer als 0,05 mbar oder größer als 0,1 mbar ist,
und dass der Druck beim Ätzen vorzugsweise kleiner als 0,5 mbar oder kleiner als 0,25 mbar ist.

7. Verfahren nach einem der vorhergehenden Ansprüche, **dadurch gekennzeichnet, dass** die Plasmaerzeugung mit Leistungen zwischen 300 Watt und 1200 Watt oder zwischen 500 Watt und 1000 Watt erfolgt, insbesondere mit 600 Watt, und dass vorzugsweise die Frequenz zur Erzeugung des Plasmas kleiner als 100 MHz ist.

8. Verfahren nach einem der vorhergehenden Ansprüche, **dadurch gekennzeichnet , dass** eine Substratspannung mit Leistungen größer 50 Watt oder größer 60 Watt erzeugt wird, vorzugsweise mit Leistungen größer 70 Watt, wobei die Leistung vorzugsweise kleiner als 700 Watt ist, und/oder dass eine Substratvorspannung betragsmäßig größer 150 Volt oder größer 180 Volt oder größer 210 Volt erzeugt wird,
wobei die Substratvorspannung betragsmäßig vorzugsweise kleiner 600 Volt ist,
und dass vorzugsweise die Frequenz zum Erzeugen der Substratvorspannung kleiner als 100 MHz ist.

9. Verfahren nach einem der vorhergehenden Ansprüche, **dadurch gekennzeichnet, dass** die folgenden Werte gelten oder dass Werte gelten, die um höchstens plus oder minus fünf Prozent oder um höchstens plus oder minus zehn Prozent von den genannten Werten abweichen:
Gasdruck 120 µbar,
Plasmaleistung 600 Watt,
Substratvorspannung -220 Volt,
Heliumgasfluss 126 sccm,
Sauerstoffgasfluss 32 sccm,
Schwefelhexafluoridgasfluss 59 sccm,
Argongasfluss 84 sccm,
wobei vorzugsweise keine weiteren Gase verwendet werden,
oder dass die folgenden Werte gelten oder dass Werte gelten,
die um höchstens plus oder minus fünf Prozent oder um höchstens plus oder minus zehn Prozent von den genannten Werten abweichen:
Gasdruck 93 µbar,
Plasmaleistung 700 Watt,
Substratvorspannung -200 Volt,
Heliumgasfluss 131 sccm,
Sauerstoffgasfluss 35 sccm,
Schwefelhexafluoridgasfluss 53 sccm,
Argongasfluss 131 sccm,
wobei vorzugsweise keine weiteren Gase verwendet werden,
oder dass die folgenden Werte gelten oder dass Werte gelten,
die um höchstens plus oder minus fünf Prozent oder um höchstens plus oder minus zehn Prozent von den genannten Werten abweichen:
Gasdruck 120 µbar,
Plasmaleistung 800 Watt,
Substratvorspannung -220 Volt,
Heliumgasfluss 112 sccm,
Sauerstoffgasfluss 50 sccm,
Schwefelhexafluoridgasfluss 66 sccm,
Argongasfluss 168 sccm,
wobei vorzugsweise keine weiteren Gase verwendet werden.

10. Verfahren nach einem der vorhergehenden Ansprüche, **dadurch gekennzeichnet, dass** die Ausnehmung (72) ein Graben oder ein Loch ist,
und/oder dass das Aspektverhältnis zwischen kleinster lateraler Abmessung am Rand der Ausnehmung (72) und der kontinuierlich geätzten Tiefe (T) der Ausnehmung (72) größer als 8:1 oder größer als 10:1 ist,
und/oder dass die kleinste laterale Abmessung am Rand der Aussparung (72) kleiner als zwanzig Mikrometer oder kleiner als zehn Mikrometer ist,
und/oder dass der Anteil der Öffnung der Ausnehmung (72) oder der Öffnungen der Ausnehmung (72) bezogen auf die Größe der ursprünglichen Substratoberfläche, in die die Ausnehmung (72) eingebracht wird, kleiner als 20 % oder kleiner als 10 % oder kleiner als 5 % ist.

11. Verfahren nach einem der vorhergehenden Ansprüche, **dadurch gekennzeichnet, dass** der Neigungswinkel (W2) einer Wand einer sich mit zunehmenden Abstand zur Substratoberfläche verjüngenden Ausnehmung zu der den Rand der Aussparung enthaltenden Substratoberfläche größer als 91 Grad größer als 92 Grad oder größer als 93 Grad ist, wobei der Neigungswinkel (W2) vorzugsweise kleiner als 110 Grad ist, und wobei der Neigungswinkel (W2) vorzugsweise über einen Sauerstoffanteil im Prozessgas eingestellt wird.

12. Verfahren nach einem der vorhergehenden Ansprüche, **dadurch gekennzeichnet, dass** in eine zum Ätzen genutzte Ätzkammer von außen kein siliziumhaltiges Gas eingeleitet wird.

13. Verfahren nach Anspruch 12, **dadurch gekennzeich**n e t , dass das Gas kein Gas mit Verbindungen ist, die Silizium und Fluor enthalten.

14. Verfahren nach einem der vorhergehenden Ansprüche, **dadurch gekennzeichnet, dass** der Gesamtgasfluss zwischen 200 und 500 sccm oder zwischen 250 und 350 sccm liegt, vorzugsweise zwischen 295 und 305 sccm,
und/oder dass das Kammervolumen der Ätzkammer 30 Liter beträgt oder dass der Gesamtgasfluss unter gleichbleibender Verweilzeiten auf ein anderes Kammervolumen umgerechnet ist.

15. Verwendung einer Plasmaätzanlage (10) in einem Verfahren nach einem der vorhergehenden Ansprüche für das Ätzen mindestens einer Ausnehmung (72) mit einer Tiefe (T) größer als fünfzig Mikrometer oder größer als fünfundsiebzig Mikrometer oder größer als einhundert Mikrometer bei kontinuierlichem Gasfluss ohne zwischenzeitliche Unterbrechung von in eine Ätzkammer der Plasmaätzanlage (10) einströmenden Gasen.

16. Verwendung nach Anspruch 15, **dadurch gekennzeich**n e t , dass die Plasmaätzanlage keine Steuereinheit für ein zyklisches Ätzen enthält.

17. Verwendung nach Anspruch 15 oder 16, **dadurch gekennzeichnet, dass** die Größe des Gasflusses während des Ätzens der Ausnehmung gleich bleibt.

18. Verwendung nach einem der Ansprüche 15 bis 17, **dadurch gekennzeichnet, dass** die Plasmaätzanlage (10) eine Plasmaquelle (24, 50) enthält, in die Energie induktiv oder durch Mikrowelleneinstrahlung eingekoppelt wird, und/oder dass die Plasmaätzanlage (10) eine Anlage vom Typ Lam TCP 9400 PTX ist.

## Claims

1. Method for anisotropically etching a recess (72) in a silicon substrate (22),
in which a plasma is used for energetic excitation of a reactive etching gas,
in which the reactive etching gas is a constituent of a continuous gas flow,
and in which at least one recess (72) is deepened by at least seventy-five micrometers or by at least one hundred micrometers without interrupting the gas flow in the meantime,
wherein the reactive etching gas contains a fluorine-free additional gas, namely an oxide forming agent, and wherein the etching gas is diluted with only one inert gas or noble gas or with a plurality of inert gases or noble gases,
and wherein the proportion contributed by the fluorine-free additional gas in the total active gas flow lies between 30% and 40%,
and wherein the proportion contributed by the gas flow of reactive etching gas in the total gas flow lies in the range of between 25% and 35%,
and wherein an etching mask (70) made of silicon dioxide is used for defining the position of the recess (72),
and wherein the composition of the gas flow remains the same during the etching of the recess (72).

2. Method according to Claim 1, **characterized in that** the reactive etching gas contains fluorine or fluorine compounds, preferably sulfur hexafluoride SF₆ and/or nitrogen trifluoride NF₃, in particular only one type of fluorine compounds.

3. Method according to Claim 1 or 2, **characterized in that** the reactive gas contains molecular oxygen, and/or in that the proportion contributed by the fluorine-free additional gas, in particular the proportion contributed by the oxygen gas flow, in the total active gas flow is 35%.

4. Method according to one of the preceding claims, **characterized in that** the etching gas contains helium or argon, or **in that** the etching gas contains helium and argon,
and/or **in that** the proportion contributed by the argon gas flow in the total inert gas flow lies between 25% and 65% or between 35% and 55%.

5. Method according to one of the preceding claims, **characterized in that** the proportion contributed by the gas flow comprising reactive etching gas in the total gas flow lies in the range of between 28% and 32%.

6. Method according to one of the preceding clams, **characterized in that** the method according to one of the preceding claims, **characterized in that** the pressure during etching is greater than 0.05 mbar or greater than 0.1 mbar,
and **in that** the pressure during etching is preferably less than 0.5 mbar or less than 0.25 mbar.

7. Method according to one of the preceding claims, **characterized in that** the plasma is generated with powers of between 300 watts and 1200 watts or between 500 watts and 1000 watts, in particular with 600 watts, and **in that** the frequency for generating the plasma is preferably less than 100 MHz.

8. Method according to one of the preceding claims, **characterized in that** a substrate voltage is generated with powers of greater than 50 watts or greater than 60 watts, preferably with powers of greater than 70 watts,
the power preferably being less than 700 watts, and/or in that a substrate bias voltage is generated with a magnitude of greater than 150 volts or greater than 180 volts or greater than 210 volts, the substrate bias voltage having a magnitude preferably less than 600 volts,
and **in that** the frequency for generating the substrate bias voltage is preferably less than 100 MHz.

9. Method according to one of the preceding claims, **characterized in that** the following values hold true or in that values hold true which deviate by at most plus or minus five percent or by at most plus or minus ten percent from the values stated:
gas pressure 120 µbar,
plasma power 600 watts,
substrate bias voltage -220 volts,
helium gas flow 126 sccm,
oxygen gas flow 32 sccm,
sulfur hexafluoride gas flow 59 sccm,
argon gas flow 84 sccm,
preferably no further gases being used,
or **in that** the following values hold true or **in that** values hold true which deviate by at most plus or minus five percent or by at most plus or minus ten percent from the values stated:
gas pressure 93 µbar,
plasma power 700 watts,
substrate bias voltage -200 volts,
helium gas flow 131 sccm,
oxygen gas flow 35 sccm,
sulfur hexafluoride gas flow 53 sccm,
argon gas flow 131 sccm,
preferably no further gases being used,
or **in that** the following values hold true or **in that** values hold true which deviate by at most plus or minus five percent or by at most plus or minus ten percent from the values stated:
gas pressure 120 µbar,
plasma power 800 watts,
substrate bias voltage -220 volts,
helium gas flow 112 sccm,
oxygen gas flow 50 sccm,
sulfur hexafluoride gas flow 66 sccm,
argon gas flow 168 sccm,
preferably no further gases being used.

10. Method according to one of the preceding claims, **characterized in that** the recess (72) is a trench or a hole,
and/or **in that** the aspect ratio between the smallest lateral dimension at the edge of the recess (72) and the continuously etched depth (T) of the recess (72) is greater than 8:1 or greater than 10:1,
and/or **in that** the smallest lateral dimension at the edge of the cutout (72) is less than twenty micrometers or less than ten micrometers,
and/or **in that** the proportion made up by the opening of the recess (72) or the openings of the recess (72) relative to the size of the original substrate surface into which the recess (72) is introduced is less than 20% or less than 10% or less than 5%.

11. Method according to one of the preceding claims, **characterized in that** the angle (W2) of inclination of a wall of a recess that tapers with increasing distance from the substrate surface with respect to the substrate surface containing the edge of the cutout is greater than 91 degrees, greater than 92 degrees or greater than 93 degrees, the angle (W2) of inclination preferably being less than 110 degrees, and the angle (W2) of inclination preferably being set by way of an oxygen proportion in the process gas.

12. Method according to one of the preceding claims, **characterized in that** no silicon-containing gas is introduced externally into an etching chamber utilized for etching.

13. Method according to Claim 12, **characterized in that** the gas is not a gas with compounds containing silicon and fluorine.

14. Method according to one of the preceding claims, **characterized in that** the total gas flow lies between 200 and 500 sccm or between 250 and 350 sccm, preferably between 295 and 305 sccm,
and/or **in that** the chamber volume of the etching chamber is 30 liters, or **in that** the total gas flow is converted to a different chamber volume with residence times remaining the same.

15. Use of a plasma etching system (10) in a method according to one of the preceding claims, for the etching of at least one recess (72) having a depth (T) of greater than fifty micrometers or greater than seventy-five micrometers or greater than one hundred micrometers with continuous gas flow without gases which flow into an etching chamber of the plasma etching system (10) being interrupted in the meantime.

16. Use according to Claim 15, **characterized in that** the plasma etching system does not contain a control unit for cyclic etching.

17. Use according to Claim 15 or 16, **characterized in that** the magnitude of the gas flow remains the same during the etching of the recess.

18. Use according to one of Claims 15 to 17, **characterized in that** the plasma etching system (10) contains a plasma source (24, 50), into which energy is coupled inductively or by radiating in microwave radiation,
and/or **in that** the plasma etching system (10) is a system of the type Lam TCP 9400 PTX.

## Revendications

1. Procédé pour former par attaque anisotrope un évidement (72) dans un substrat (22) de silicium,
dans lequel on utilise un plasma pour l'excitation énergétique d'un gaz d'attaque réactif,
dans lequel le gaz d'attaque réactif fait partie d'un flux gazeux continu,
et dans lequel, sans interruption intermédiaire dans le temps du flux gazeux, on creuse au moins un évidement (72) d'au moins 75 microns ou d'au moins 100 microns,
dans lequel le gaz d'attaque réactif contient un additif gazeux exempt de fluor, à savoir un agent de formation d'un oxyde et dans lequel le gaz d'attaque est dilué seulement par un gaz inerte ou un gaz rare ou par plusieurs gaz inertes ou plusieurs gaz rares,
et dans lequel la proportion de l'additif gazeux exempt de fluor par rapport à tout le flux gazeux actif est comprise entre 30% et 40%,
et dans lequel la proportion du gaz d'attaque réactif dans le flux gazeux par rapport à tout le flux gazeux est comprise entre 25% et 35%,
et dans lequel on utilise un masque (70) d'attaque en dioxyde de silicium pour fixer la position de l'évidement (72),
et dans lequel la composition du flux gazeux reste la même pendant l'attaque de l'évidement (72).

2. Procédé suivant la revendication **caractérisé en ce que** le gaz d'attaque réactif contient du fluor ou des composés fluorés, de préférence de l'hexafluorure de soufre SF₆ et/ou du trifluorure d'azote NF₃, notamment seulement un type de composé fluoré.

3. Procédé suivant la revendication 1 ou 2, **caractérisé en ce que** le gaz d'attaque réactif contient de l'oxygène moléculaire,
et/ou **en ce que** la proportion de l'additif gazeux exempt de fluor, notamment la proportion du flux d'oxygène gazeux, par rapport à tout le flux du gaz réactif est de 35%.

4. Procédé suivant l'une des revendications précédentes, **caractérisé en ce que** le gaz d'attaque contient de l'hélium ou de l'argon ou **en ce que** le gaz d'attaque contient de l'hélium et de l'argon,
et/ou **en ce que** la proportion du flux d'argon gazeux par rapport à tout le flux gazeux inerte est comprise entre 25% et 65% ou entre 35% et 55%.

5. Procédé suivant l'une des revendications précédentes, **caractérisé en ce que** la proportion de gaz d'attaque réactif du flux gazeux par rapport à tout le flux gazeux est comprise entre 28% et 32%.

6. Procédé suivant l'une des revendications précédentes, **caractérisé en ce que** la pression lors de l'attaque est supérieure à 0,05 mbar ou supérieure à 0,1 mbar,
et **en ce que** la pression lors de l'attaque est, de préférence, inférieure à 0,5 mbar ou inférieure à 0,25 mbar.

7. Procédé suivant l'une des revendications précédentes, **caractérisé en ce que** l'on effectue la production de plasma à des puissances comprises entre 300 Watt et 1200 Watt ou entre 500 Watt et 1000 Watt, notamment de 600 Watt, et **en ce que**, de préférence, la fréquence de production du plasma est plus petite que 100 MHz.

8. Procédé suivant l'une des revendications précédentes, **caractérisé en ce que** l'on produit une tension de substrat ayant des puissances plus grandes que 50 Watt ou plus grande que 60 Watt, en ayant, de préférence, des puissances plus grandes que 70 Watt, la puissance étant, de préférence, plus petite que 700 Watt et/ou **en ce que** l'on produit une tension de polarisation du substrat plus grande en valeur absolue que 150 Volt ou que 180 Volt ou que 210 Volt,
dans lequel la tension de polarisation du substrat est, de préférence, plus petite que 600 Volt en valeur absolue,
et **en ce que** la fréquence de production de la tension de polarisation du substrat est, de préférence, plus petite que 100 MHz.

9. Procédé suivant l'une des revendications précédentes, **caractérisé en ce que** l'on a les valeurs suivantes ou **en ce que** l'on a des valeurs qui s'écartent en plus ou en moins de cinq pourcent ou en plus ou en moins de dix pourcent des valeurs mentionnées :
pression du gaz 120 µbar,
puissance du plasma 600 Watt,
tension de polarisation du substrat -220 Volt,
flux d'hélium gazeux 126 sccm,
flux d'oxygène gazeux 32 sccm,
flux d'hexafluorure de soufre gazeux 59 sccm,
flux d'argon 84 sccm,
dans lequel on n'utilise pas, de préférence, d'autres gaz,
ou on a les valeurs suivantes ou des valeurs qui s'écartent au plus en plus ou en moins de cinq pourcent ou au plus en plus ou en moins de dix pourcent des valeurs mentionnées :
pression du gaz 93 µbar,
puissance du plasma 700 Watt,
tension de polarisation du substrat -200 Volt,
flux d'hélium gazeux 131 sccm,
flux d'oxygène gazeux 35 sccm,
flux d'hexafluorure de soufre gazeux 53 sccm,
flux d'argon 131 sccm,
dans lequel on n'utilise pas, de préférence, d'autres gaz,
ou **en ce que** l'on a les valeurs suivantes ou des valeurs qui s'écartent au plus en plus ou en moins de cinq pourcent ou au plus en plus en moins de dix pourcent des valeurs mentionnées :
pression du gaz 120 µbar,
puissance du plasma 800 Watt,
tension de polarisation du substrat -220 Volt,
flux d'hélium gazeux 112 sccm,
flux d'oxygène gazeux 50 sccm,
flux d'hexafluorure de soufre gazeux 66 sccm,
flux d'argon 1168 sccm,
dans lequel on utilise de préférence pas d'autres gaz.

10. Procédé suivant l'une des revendications précédentes, **caractérisé en ce que** l'évidement (72) est un sillon ou un trou,
et/ou le rapport d'aspect entre la dimension latérale la plus petite au bord de l'évidement (72) et la profondeur (T) ménagée en continu de l'évidement (72) est plus grand que 8:1 ou plus grand que 10:1,
et/ou **en ce que** la dimension latérale la plus petite au bord de l'évidement (72) est plus petite que vingt microns ou plus petite que dix microns,
et/ou **en ce que** la proportion de l'ouverture de l'évidement (72) ou des ouvertures de l'évidement (72) rapportée à la dimension de la surface d'origine du substrat, dans lequel l'évidement (72) est ménagé, est plus petite que 20% ou est plus petite que 10% ou est plus petite que 5%.

11. Procédé suivant l'une des revendications précédentes, **caractérisé en ce que** l'angle (W2) d'inclinaison d'une paroi d'un évidement se rétrécissant au fur et à mesure qu'augmente la distance à la surface du substrat à la surface du substrat contenant le bord de l'évidement est plus grand que 91 degrés, plus grand que 92 degrés ou plus grand que 93 degrés, l'angle (W2) d'inclinaison étant de préférence plus petit que 110 degrés, et l'angle (W2) d'inclinaison étant réglé, de préférence, par une proportion d'oxygène dans le gaz de processus.

12. Procédé suivant l'une des revendications précédentes, **caractérisé en ce que** l'on n'introduit pas de gaz silicié de l'extérieur dans une chambre d'attaque utilisée pour l'attaque.

13. Procédé suivant la revendication 12, **caractérisé en ce que** le gaz n'est pas un gaz contenant des composés qui contiennent du silicium et du fluor.

14. Procédé suivant l'une des revendications précédentes, **caractérisé en ce que** le flux gazeux total est compris entre 200 et 500 sccm ou entre 250 et 350 sccm, en étant, de préférence, compris entre 295 et 305 sccm,
et/ou **en ce que** le volume de la chambre d'attaque est de 30 litres ou **en ce que** le flux gazeux total est, pour des temps de séjour restant les mêmes, transformé en un autre volume de chambre.

15. Utilisation d'une installation (10) d'attaque par plasma dans un procédé suivant l'une des revendications précédentes pour ménager par attaque au moins un évidement (72) d'une profondeur (T) plus grande que cinquante microns, plus grande que soixante quinze microns ou plus grande que cent microns pour un flux gazeux continu sans interruption intermédiaire dans le temps de gaz pénétrant dans une chambre d'attaque de l'installation (10) d'attaque par plasma.

16. Utilisation suivant la revendication 15, **caractérisée en ce que** l'installation d'attaque par plasma ne contient pas d'unités de commande pour une attaque cyclique.

17. Utilisation suivant la revendication 15 ou 16, **caractérisée en ce que** la valeur du flux gazeux reste constante pendant que l'évidement est ménagé par attaque.

18. Utilisation suivant l'une des revendications 15 à 17, **caractérisée en ce que** l'installation (10) d'attaque par plasma comporte une source (24, 50) de plasma, dans laquelle de l'énergie est injectée par induction ou par rayonnement micro-ondes et/ou **en ce que** l'installation (10) d'attaque par plasma est une installation du type Lam TCP 9400 PTX.
